# EUROPÄISCHE PATENTANMELDUNG

(11) **EP 0 831 534 A2**
(43) Veröffentlichungstag der Anmeldung: **25.03.1998**
(21) Anmeldenummer: 97115838.1
(22) Anmeldetag: 11.09.1997
(51) Int. Cl.: H01L 29/06, H01L 23/31, H01L 21/312

(54) **Halbleiterbauelement mit einer Passivierungsschicht**

(30) Priorität: 24.09.1996 DE 19639245
(71) Anmelder: SIEMENS AKTIENGESELLSCHAFT, 80333 München (DE)
(72) Erfinder: Hammerschmidt, Albert, Dr., 91056 Erlangen (DE)

(57) **Zusammenfassung**

Bei Halbleiterbauelementen mit einem Halbleiterkörper mit wenigstens einem an dessen Oberfläche tretenden pn-Übergang und mit einer Passivierungsschicht werden durch Feuchtigkeit oder Ionen bedingte Instabilitäten dann unterbunden, wenn die Passivierungsschicht aus Polybenzoxazol besteht.

## Beschreibung

Die Erfindung betrifft ein Halbleiterbauelement mit einem Halbleiterkörper mit wenigstens einem an die Oberfläche des Halbleiterkörpers tretenden pn-Übergang und mit einer Passivierungsschicht.

In diskreten Halbleiterbauelementen, wie Leistungsdioden, Thyristoren und Gate-turn-off-Thyristoren, reichen die pn-Übergänge und damit die Raumladungszonen bis an den Rand der Bauelemente. Die Randbereiche der Halbleiterbauelemente sind meistens mit Siliconkautschuk geschützt, um in diesen Bereichen Überschläge zu verhindern. Trotzdem sind diese Bereiche empfindlich gegen Störungen von außen in Form von - gegebenenfalls im elektrischen Feld wandernden - Ladungen; hierdurch kann nämlich der Verlauf der Raumladungszone beeinflußt werden. Im sperrgepolten Zustand können Oberflächenladungen die Raumladungszonen so verbiegen, daß diese an Kontakte stoßen ( 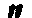 punch through") oder daß am Rand Felderhöhungen auftreten. Im ersten Fall sind stark erhöhte Sperrströme die Folge, im zweiten Fall kann es zu einem Ladungsdurchbruch am Rand kommen, was eine Zerstörung des Halbleiterbauelementes zur Folge haben kann. Ferner können wandernde Ladungen, beispielsweise hydratisierte Ionen, zu zeitlichen Veränderungen der Kennliniencharakteristik, d.h. der zeitlichen Stabilität des Halbleiterbauelementes, führen, was nicht tolerierbar ist.

Bei Halbleiterbauelementen, bei denen besonders die Randpassivierung wichtig ist, beispielsweise höher sperrende Bauelemente mit Sperrspannungen > 4 kV, wird derzeit eine funktionsfähige Randpassivierung dadurch erhalten, daß Schichten aus amorphem Silicium a-Si bzw. dotiertem amorphem Silicium (DE-PS 27 30 367 und EP-PS 0 400 178) oder aus amorphem wasserstoffhaltigem Kohlenstoff a-C:H (EP-PS 0 381 111 und EP-PS 0 400 178) aufgebracht werden. Die Passivierungsschichten aus a-Si werden dabei mittels eines Elektronenstrahl-Verdampfungsverfahrens erzeugt, die a-C:H-Schichten werden aus gasförmigen Kohlenwasserstoffen durch ein plasmaunterstütztes CVD-Verfahren hergestellt.

Bei niedriger sperrenden Bauelementen wird - aus wirtschaftlichen Gründen - meistens auf eine derartige 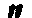 elektroaktive" Passivierung verzichtet. Hier werden vielmehr elektrisch isolierende Schichten aufgebracht (dielektrische Passivierung), die im Volumen keine Ladung besitzen, beispielsweise anorganische Gläser (DD-PS 258 875, DE-OS 21 28 039, DE-OS 24 40 917 und DE-OS 38 32 731) . Problematisch ist dabei allerdings das unterschiedliche Ausdehnungsverhalten von Glas und Substrat, was - im Extremfall - zu Sprüngen in der Passivierungsschicht führen kann.

Dieses Problem kann an sich durch die Verwendung organischer duktiler Polymerer gelöst werden, beispielsweise durch Siliconkautschuk (DD-PS 129 600, DD-PS 266 476, EP-OS 0 246 539 und JP-OS 56-040249), gegebenenfalls siloxanhaltige Polyimide (JP-OS 54-074677, JP-OS 63-015424 und EP-OS 0 246 539) oder Polyimid/Siliconkautschuk-Mischungen bzw. -Copoloymere (JP-OS 54-074677, JP-OS 56-040249 und GB-PS 2 095 904). Von Siloxanen ist jedoch bekannt, daß sie eine hohe Durchlässigkeit für Wasserdampf besitzen, Poly(dimethylsiloxan) beispielsweise 43000 · 10⁻¹⁰ cm³(STP)·cm/cm²·s·cmHg (siehe: 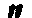 Journal of Membrane Science", Vol. 18 (1984), Seiten 273 bis 284), und Kapton 300 bis 600 · 10⁻¹⁰ cm³(STP)·cm/cm²·s·cmHg (siehe: 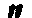 Journal of Applied Polymer Science", Vol. 23 (1979), Seiten 2355 bis 2364). Polyimide andererseits zeigen eine hohe Feuchteaufnahme, die für Filme - je nach Art des Polymers und der Bedingungen beim Temperprozeß - mehr als 6 Gew.-% betragen kann, und zwar zwischen 0 und 100 % relativer Feuchte (A. Hammerschmidt et al., 1st European Technical Symposium on Polyimides, 10. und 11. Mai 1989, Montpellier, Frankreich). Dies bedeutet, daß durch Feuchtigkeit, die an die pn-Übergänge diffundieren kann, oder durch Ionen, die in den Polymeren als Verunreinigungen vorhanden sind und möglicherweise im elektrischen Feld wandern, Instabilitäten induziert werden, welche die Halbleiterbauelemente unbrauchbar machen können.

Aufgabe der Erfindung ist es, Halbleiterbauelemente der eingangs genannten Art, die mit einer Passivierungsschicht zur Vermeidung von Störungen durch Oberflächenladungen versehen sind, in der Weise auszugestalten, daß keine durch Feuchtigkeit oder Ionen bedingte Instabilitäten auftreten können.

Dies wird erfindungsgemäß dadurch erreicht, daß die Passivierungsschicht aus Polybenzoxazol besteht.

Polybenzoxazole sind organische Polymere mit Benzoxazol-Einheiten als charakteristisches Kettensegment und weisen beispielsweise folgende Struktur auf:

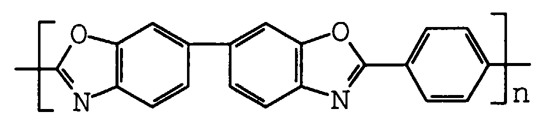

Polybenzoxazole zeigen eine deutlich niedrigere Feuchteaufnahme als Polyimide und besitzen mindestens die gleiche Hochtemperaturstabilität. Außerdem können Polybenzoxazole - über chloridfreie Synthesen - frei von ionischen Verunreinigungen hergestellt werden (siehe dazu: EP-OS 0 158 726 und EP-OS 0 391 196).

Die Dicke der Passivierungsschicht aus Polybenzoxazol beträgt im allgemeinen etwa 1 bis 200 µm, vorzugsweise 5 bis 200 µm.

Die Passivierungsschicht kann Additive enthalten, d.h. dem Polyoxazol können Hilfsstoffe, wie Haftvermittler, Benetzungsmittel und Füllstoffe, zugegeben werden.

Bei den Halbleiterbauelementen nach der Erfindung wird bei der Herstellung der Passivierungsschicht folgendermaßen vorgegangen. Auf die pn-Übergänge der Halbleiterkörper wird eine Lösung des Polybenzoxazols in einem geeigneten Lösemittel aufgebracht, und anschließend wird getrocknet, d.h. das Lösemittel entfernt; dies geschieht im allgemeinen bei Temperaturen bis ca. 200°C. Das Aufbringen der Lösung auf den Rand der Halbleiterbauelemente, an dem die pn-Übergänge auftreten und der als Planarrand oder konkav (sogenannter Schwalbenschwanzrand) ausgebildet sein kann, erfolgt beispielsweise mit Hilfe eines Pinsels oder eines Dispensers oder durch Aufsprühen.

Insbesondere wenn die Polybenzoxazole (in der cyclisierten Endstruktur) in organischen Lösemitteln unlöslich sind, dann werden zur Herstellung der Passivierungsschicht lösliche Polybenzoxazol-Vorstufen eingesetzt. Hierbei wird dann eine Lösung der Polymer-Vorstufe auf die pn-Übergänge aufgebracht, und anschließend wird getrocknet. Nachfolgend wird bei Temperaturen < 500°C, vorzugsweise bei Temperaturen bis ca. 400°C, getempert.

Bei den löslichen Polybenzoxazol-Vorstufen handelt es sich um sogenannte Hydroxypolyamide. Diese Vorstufen unterliegen bei der Temperung einer Cyclisierung und werden dabei in die Polybenzoxazole übergeführt. Die Herstellung der Hydroxypolyamide und die Umwandlung in Polybenzoxazole ist an sich bekannt. Hierzu wird ausdrücklich auf den insbesondere aus den Druckschriften EP-OS 0 158 726, EP-OS 0 291 778, EP-OS 0 391 196 und EP-OS 0 512 339 bekannten Stand der Technik Bezug genommen, der als Bestandteil der vorliegenden Patentanmeldung gelten soll.

Bei beiden der genannten Herstellungsmöglichkeiten können vor dem Trocknen Luftbläschen, die sich an der Grenzfläche Silicium (Halbleiterkörper)/Polymerlösung befinden, durch eine Vakuumbehandlung entfernt werden. Außerdem kann es sich als vorteilhaft erweisen, nach dem Trocknen bzw. Tempern den Rand der Halbleiterbauelemente - zum zusätzlichen Schutz - mit Siliconkautschuk zu vergießen, um Spannungsüberschläge zu vermeiden.

Anhand eines Ausführungsbeispiels soll die Erfindung noch näher erläutert werden.

25 Gewichtsteile einer Polybenzoxazol-Vorstufe, hergestellt aus 2,2-Bis(3-amino-4-hydroxyphenyl)-1,1,1,3,3,3-hexafluorpropan, Isophthalsäure und Norbornendicarbonsäureanhydrid im Molverhältnis 1:0,9:0,2 (siehe dazu: EP-OS 0 512 339), werden in einem Teflongefäß in 50 Gewichtsteilen N-Methylpyrrolidon (hochrein, für die Mikroelektronik) gelöst; die Lösung wird dann durch ein 0,8 µm-Filter druckfiltriert. Ein Leistungshalbleiterbauelement, beispielsweise eine Diode, dessen Rand frisch mit Ätzsäure (HNO₃/HF-Gemisch) geätzt und anschließend mit Wasser gereinigt und getrocknet wurde, wird in eine die Kontakte abdichtende Vorrichtung eingespannt und am Rand mittels einer Spritze mit der in der vorstehend genannten Weise hergestellten Polymerlösung beschichtet. Um eventuelle Einschlüsse kleiner Luftbläschen zu entfernen, wird das Halbleiterbauelement anschließend in ein evakuierbares Gefäß eingebracht, dann wird 10 min ein Vakuum von ca. 10 mbar angelegt (langsame Evakuierung). Nachfolgend wird mit Stickstoff belüftet und dann in einem Umluftofen unter Stickstoff 60 min bei 150°C getrocknet. Im Anschluß daran wird je 1 h bei 250°C, 300°C und 370°C getempert. Dabei ergeben sich dunkelbraune Passivierungsschichten aus Polybenzoxazol mit einer Schichtdicke zwischen 20 und 100 µm.

## Patentansprüche

1. Halbleiterbauelement mit einem Halbleiterkörper mit wenigstens einem an die Oberfläche des Halbleiterkörpers tretenden pn-Übergang und mit einer Passivierungsschicht, **dadurch gekennzeichnet,** daß die Passivierungsschicht aus Polybenzoxazol besteht.

2. Halbleiterbauelement nach Anspruch 1, **dadurch gekennzeichnet,** daß die Passivierungsschicht eine Dicke zwischen 1 und 200 µm aufweist.

3. Halbleiterbauelement nach Anspruch 1 oder 2, **dadurch gekennzeichnet,** daß die Passivierungsschicht Additive enthält.

4. Verfahren zur Herstellung eines Halbleiterbauelementes nach einem der Ansprüche 1 bis 3, **dadurch gekennzeichnet,** daß auf den pn-Übergang des Halbleiterkörpers eine Lösung eines Polybenzoxazols aufgebracht und das Lösemittel entfernt wird.

5. Verfahren zur Herstellung eines Halbleiterbauelementes nach einem der Ansprüche 1 bis 3, **dadurch gekennzeichnet,** daß auf den pn-Übergang des Halbleiterkörpers eine Lösung einer Polybenzoxazol-Vorstufe aufgebracht und das Lösemittel entfernt wird, und daß bei einer Temperatur < 500°C getempert wird.
